# EUROPEAN PATENT APPLICATION

(11) **EP 2 690 783 A1**
(43) Date of publication of application: **29.01.2014**
(21) Application number: 12178353.4
(22) Date of filing: 27.07.2012
(51) Int. Cl.: H03K 17/081, H01L 27/02

(54) **BiCMOS electrostatic discharge protection circuit**

(71) Applicant: NXP B.V., 5656 AG Eindhoven (NL)
(72) Inventor: Abessolo Bidzo, Dolphin, 6534 AE Nijmegen (NL)
(74) Representative: Miles, John Richard

(57) **Abstract**

A BiCMOS electrostatic discharge circuit for an integrated circuit is disclosed. The electrostatic discharge circuit comprises a bipolar transistor having a collector connected to an Input/output, I/O, terminal of the integrated circuit, and having an emitter connected to a reference voltage. A diode is connected between the I/O terminal and the reference voltage, and a voltage divider is connected between the IO terminal and the reference voltage, the voltage divider being adapted to divide an input voltage present on the I/O terminal and to supply the divided voltage to an output terminal of the ESD circuit. The bipolar transistor is adapted to be biased to turn on when an ESD transient occurs at the I/O terminal.

## Description

This invention relates to an ElectroStatic Discharge (ESD) protection circuit, and more particularly to a BiCMOS ESD protection circuit for an integrated circuit.

Integrated circuits typically need protection against electrostatic discharge, hereinafter referred to as ESD. An ESD leads to a pulse of high voltage which may damage an integrated circuit if it is not led away from the integrated circuit to ground for example.

Conventionally, integrated circuits are protected against ESD using specific protection circuits or devices. Such protection circuits or devices are usually connected between an Input/Output (I/O) terminal and in the internal circuit(s), and are to shunt an ESD current to ground.

Known protection circuit or devices, however, are not suitable for protecting an Inter-Integrated Circuit (12C) (commonly referred to as 12C or I²C (and pronounced "I-squared-C")).

An 12C is a multi-master serial single-ended computer bus that is used to attach low-speed peripherals to a motherboard, embedded system, cellphone, or other electronic devices. It allows communication of data between 12C devices over two wires, wherein information is sent in a serial manner using one line for a data signal (SDA) and one for a clock signal (SCL).

12C cells cannot be ESD protected using conventional protection schemes due to the large signal swings (typically >1V) at the SDA and SCL pins. For example, a single diode between the I/O and the 12C cell would trigger in forward mode during normal operation of the 12C cell and thus result in faulty operation

Proposed is a BiCMOS ESD protection circuit for protecting an integrated circuit against damage that may be caused by ESD. In particular, a voltage divider may be employed which divides a voltage clamped by a vertical bipolar transistor, thereby ensuring that the supply of a voltage to a circuit to be protected is lower than the voltage clamped by the vertical bipolar transistor.

According to an aspect of the invention there is provided a BiCMOS ESD protection circuit for an integrated circuit according to the independent claim.

Embodiments may provide ESD protection over a wider range of voltages compared to conventional ESD circuits/devices. Accordingly, such embodiments may provide ESD protection for 12C cells that can exhibit large voltage swings between the SDL and SCL pins. Embodiments may also be used to provide ESD protection for a BiCMOS integrated circuit such as a transceiver or amplifier.

Embodiments may also be used to provide ESD protection for a serial communication bus such as an 12C multi-master serial single-ended bus. An 12C device may therefore comprise a BiCMOS ESD protection circuit according to an embodiment.

ESD protection may also be provided by embodiments of the invention, wherein the characteristics of the circuit(s) being protected are not changed by the protection circuit.

A vertical NPN transistor may be used which is biased to snapback when an ESD voltage transient occurs.

Examples of the invention will now be described in detail with reference to the accompanying drawings, in which:
Figure 1 is a schematic diagram of an ESD protection circuit according to a first embodiment of the invention;
Figure 2 is a schematic diagram of an ESD protection circuit according to another embodiment of the invention; and
Figure 3 is a graph illustrating the simulated transient response for two voltages within the embodiment of Figure 2;

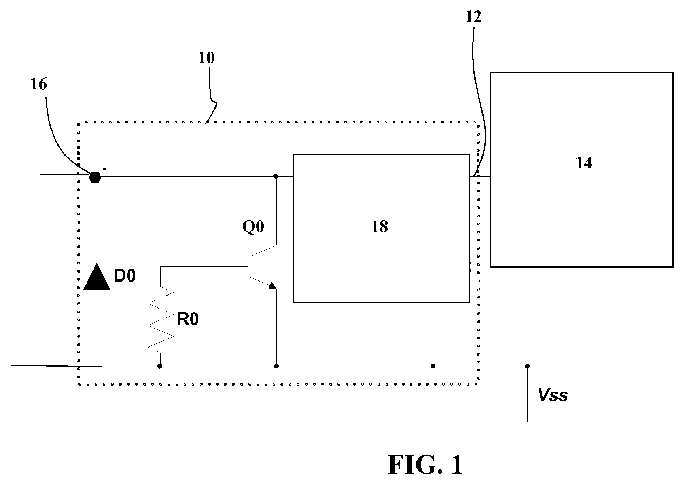

Referring to Figure 1, there is shown a basic schematic diagram of a BiCMOS ESD protection circuit 10 according to a first embodiment of the invention. The ESD protection circuit 10 is connected to an interface pin 12 of an 12C 14 so as to protect the 12C 14 from ESD damage.

The ESD protection circuit 10 comprises a vertical NPN bipolar transistor Q0 having its collector connected to an Input/output, I/O, terminal 16 of the circuit 10, and having its emitter connected to a ground or negative power supply voltage Vss. The base and emitter of the bipolar transistor Q0 are interconnected by a base resistance R0, which can be the resistance of the base region of the bipolar transistor Q0.

A diode D0 is connected in parallel with the bipolar transistor Q0 between the I/O terminal 16 of the circuit 10 and the ground reference voltage Vss. If the NPN bipolar transistor Q0 is fabricated in an N-doped region formed in a P-doped substrate, the diode D0 may be that formed by the N-doped region and the P-doped substrate.

A voltage divider 18 is also connected in parallel with the bipolar transistor Q0 between the I/O terminal 16 of the circuit 10 and the ground reference voltage Vss. The voltage divider 18 is adapted to divide an input voltage present on the I/O terminal 16 and to supply the divided voltage to the interface pin 12 of the 12C 14.

The vertical NPN transistor Q0 acts as an ESD clamp which can clamp the I/O terminal 16 to the breakdown voltage BV_{CEO} of the transistor Q0 (i.e. the breakdown voltage between the collector and emitter terminals when the collector terminal is biased in the reverse direction with respect to the emitter terminal, and the base terminal is open-circuited). Here, it will be appreciated that the collector terminal is considered to be biased in the reverse direction when it is made positive for NPN transistors or negative for PNP transistors with respect to the emitter terminal.

In particular, the vertical NPN transistor Q0 clamps the I/O terminal 16 to the breakdown voltage BV_{CEO} of the transistor Q0 when a voltage exceeding the breakdown voltage BV_{CES} of the transistor Q0 is applied to the I/O terminal 16, wherein BV_{CES} is the breakdown voltage between the collector and emitter terminals when the collector terminal is biased in the reverse direction with respect to the emitter terminal, and the base terminal is shortcircuited to the emitter terminal.

When a voltage below the breakdown voltage BV_{CES} of the transistor Q0 is applied to the I/O terminal 16, the vertical NPN transistor Q0 clamp appears as an open circuit.

In use, the vertical NPN transistor Q0 clamp will break down from collector to base to limit positive electrostatic discharge. When a voltage below the breakdown voltage BV_{CES} of the transistor Q0 is applied to the I/O terminal 16, the transistor Q0 clamp will act as an open circuit. When a voltage above the breakdown voltage BV_{CES} of the transistor Q0 is applied to the I/O terminal 16, the transistor Q0 will begin conducting current. At least part of the current flows through the base resistance R0 thereby causing a voltage drop across the base resistance. When this voltage drop exceeds the base-emitter forward voltage, the transistor Q0 turns on and current flows into the emitter causing the voltage to snap back to BV_{CEO} and remain there until the emitter current drops back to a low level (which will occur at the end of the ESD pulse. Thus, the vertical NPN transistor Q0 clamp operates in snapback mode when an ESD voltage transient occurs at the I/O terminal 16 so as to limit the dissipated power. In other words, the transistor Q0 is adapted to be biased to turn on when an ESD voltage transient occurs at the I/O terminal 16 so as to discharge the ESD in a controlled manner.

The voltage divider 18 divides the clamped voltage on the I/O terminal so as to supply a voltage to the interface pin 12 of the 12C 14 which is lower than the clamped voltage. In other words, the voltage applied to the circuit to be protected (i.e. the 12C 14) will be lower than the voltage clamped by the transistor Q0.

By way of example, Table 1 below details the various ESD characteristics for a vertical NPN transistor and various values of the base resistance R0.

**Table 1**

| | ESD Characteristics | | | |
|---|---|---|---|---|
| Base Resistance R0 (kΩ) | Triggering Voltage (Volts) | Holding Voltage (Volts) | Voltage at Failure (Volts) | Failure Current (Amps) |
| 10kΩ | 11.1 | 4.5 | 9.3 | 1.03 |
| 100kΩ | 9.9 | 3.6 | 7.5 | 0.92 |
| 1MΩ | 7.5 | 3.3 | 9.1 | 1.07 |

It will therefore be appreciated that the trigger voltage of the transistor Q0 is dependent on the base resistance R0.

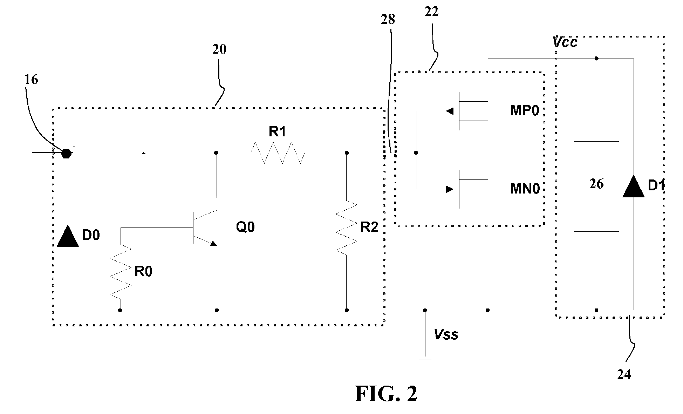

Referring now to Figure 2, there is shown a basic schematic diagram of a BiCMOS ESD protection circuit 20 according to another embodiment of the invention. The ESD protection circuit 20 is connected to a circuit to be protected which is an inverter circuit 22 comprising a PMOS transistor and NMOS transistor connected in series between a supply voltage Vcc and a ground or negative power supply voltage Vss.

Here, the ESD protection circuit 20 is similar to that shown in Figure 1. However, in the embodiment of Figure 2, the voltage divider is formed from first R1 and second R2 resistors connected in series between the I/O terminal 16 of the circuit 20 and the ground reference voltage Vss. In other words, the voltage divider of this embodiment is connected in parallel with the bipolar transistor Q0 between the I/O terminal 16 of the circuit 10 and the ground reference voltage Vs, and comprises two resistors R1 and R2 connected in series.

Further, there is provided a second ESD protection circuit 24 connected between the supply voltage Vcc and the ground or negative power supply voltage Vss. The second ESD protection circuit 24 comprises a supply clamp device 26 for clamping the supply voltage Vcc to a predetermined value. By way of example, the supply clamp device 26 may comprise an active bipolar transistor that is adapted to clamp the supply voltage to the breakdown voltage BV_{CEO} of the bipolar transistor when an ESD voltage transient occurs in the supply voltage Vcc. The second ESD protection circuit 24 also comprises a diode D1 connected in parallel with the supply clamp device and between the supply voltage Vcc and the ground or negative power supply voltage Vss. The ESD supply clamp device 26 provides improved protection for positive ESD pulses from the power supply to negative power supply voltage Vss than for the opposite polarity stresses. Therefore, the diode D1 provides an ESD current path in the reverse direction for adequate ESD performance from the negative power supply voltage Vss to the supply voltage Vcc.

The divided voltage supplied to the output of the ESD protection circuit 20 is taken from an output terminal 28 provided between the resistors R1 and R2 of the voltage divider. Thus, the gate of each MOS transistor of the inverter circuit 22 is connected to the output terminal 28 that is situated between the resistors R1 and R2 of the voltage divider.

As explained above, with reference to the embodiment of Figure 1, the vertical NPN transistor Q0 acts as an ESD clamp which clamps the I/O terminal 16 to the breakdown voltage BV_{CEO} of the transistor Q0 when an ESD voltage transient is applied to the I/O terminal 16.

The voltage divider of the embodiment of Figure 2 is thus adapted to divide the clamped voltage on the I/O terminal and to supply a divided voltage to the output terminal 28 which is lower than the clamped voltage. In this way, the voltage applied to the inverter circuit 22 will be lower than the voltage clamped by the transistor Q0. It is also noted that the first resistor R1 of the voltage divider provides secondary ESD protection.

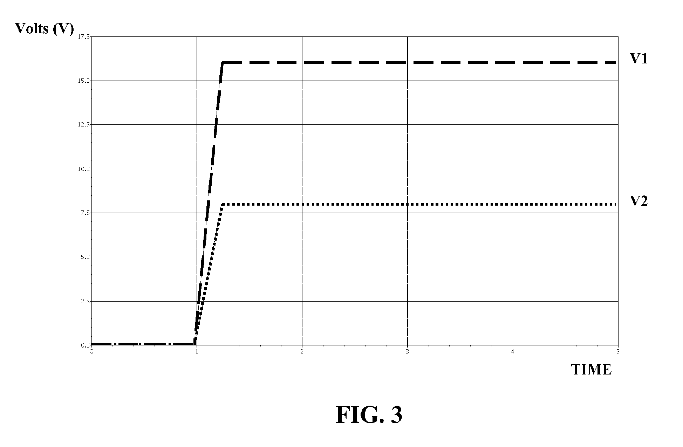

Figure 3 is a graph illustrating the simulated transient response for the voltage (V1) at the I/O terminal and the voltage (V2) at the output terminal 28 of the ESD protection circuit 20 of the embodiment of Figure 2. From the graph of Figure 3 it can be seen that the output terminal 28 of the ESD protection circuit experiences a voltage (V2) that is approximately half of the voltage (V1) at the I/O terminal 20. Thus, the embodiment of Figure 2 may provide ESD protection for integrated circuit for a wider range of input voltages compared to conventional ESD circuits/devices.

To handle large current requirements of an ESD transient, the bipolar transistor Q0 may have multiple bases and emitters formed in an NPN bipolar array. So as to ensure turn-on of the multiple elements of the array, the emitter finger may be contiguously connected. Such a contiguous arrangement can minimize any unbalance that may potentially occur when using separate emitter elements. It can also improve the ability to simultaneously turn on the multiple emitter-base elements.

It will be understood that embodiments may be used to protect an integrated circuit against damage that may be caused by ESD. Embodiments may therefore be employed to inputs/outputs of an integrated circuit such as a signal conditioner for a full spectrum transceiver, a transceiver for remote keyless entry applications, a variable gain amplifier, etc.

Further, embodiments may provide ESD protection for a serial communication bus such as an 12C multi-master serial single-ended bus, and may also be used for protecting 12C cells that can exhibit large voltage swings between the SDL and SCL pins. 12C devices may therefore comprise a BiCMOS ESD protection circuit according to an embodiment. Various modifications will be apparent to those skilled in the art.

## Claims

1. A BiCMOS electrostatic discharge, ESD, protection circuit (10) for an integrated circuit comprising:
a bipolar transistor (Q0) having a collector connected to an Input/output, I/O, terminal (16) of the integrated circuit, and having an emitter connected to a reference voltage (Vss);
a diode (D0) connected between the I/O terminal and the reference voltage; and
a voltage divider (18) connected between the I/O terminal and the reference voltage, the voltage divider being adapted to divide an input voltage present on the I/O terminal and to supply the divided voltage to an output terminal (28) of the BiCMOS ESD circuit,
wherein the bipolar transistor is adapted to be biased to turn on when an ESD transient occurs at the I/O terminal.

2. The BiCMOS ESD protection circuit of claim 1, wherein the voltage divider (18) comprises a plurality of resistors (R1,R2) connected in series, and wherein the output terminal (28) of the ESD circuit is connected to the voltage divider between two of the plurality of resistors.

3. The BiCMOS ESD protection circuit of claim 1 or 2, further comprising a resistor (R0) connected between the base of the bipolar transistor (Q0) and the reference voltage (Vss).

4. The BiCMOS ESD protection circuit of any preceding claim, wherein the bipolar transistor (Q0) comprises a plurality of bases and emitters formed in an array.

5. The BiCMOS ESD protection circuit of any preceding claim, wherein the reference voltage (Vss) is a ground voltage.

6. The BiCMOS ESD protection circuit of any preceding claim, wherein the output terminal (28) is adapted to supply the divided voltage to the interface terminal (12) of an inter-integrated circuit (14).

7. An integrated circuit comprising:
an I/O terminal;
a BiCMOS ESD protection circuit (10) according to any preceding claim, and
a primary integrated circuit (14) having an interface terminal (12),
wherein the output terminal of the BiCMOS ESD circuit is connected to the interface terminal of the primary integrated circuit.

8. The integrated circuit of claim 7, wherein the interface terminal (12) is an inter-integrated circuit interface pin.

9. The integrated circuit of claim 7 or 8, further comprising a further ESD protection circuit (24) connected to a supply voltage of the primary integrated circuit.

10. An inter-integrated circuit comprising a BiCMOS ESD protection circuit according to any of claims 1 to 6.

11. A serial communication bus comprising a BiCMOS ESD protection circuit according to any of claims 1 to 6.

12. A BiCMOS integrated circuit comprising a BiCMOS ESD protection circuit according to any of claims 1 to 6.

13. An inter-integrated circuit device comprising a BiCMOS ESD protection circuit according to any of claims 1 to 6.
